Europäisches Patentamt

(19) European Patent Office

Office européen des brevets

(11) Publication number : **0 292 957 B1**

# EUROPEAN PATENT SPECIFICATION

(12)

(45) Date of publication of patent specification :
**10.04.91 Bulletin 91/15**

(51) Int. Cl.[5] : **H01L 33/00, H01S 3/133, H01S 3/096**

(21) Application number : **88108405.7**

(22) Date of filing : **25.05.88**

(54) Temperature stabilization of laser diodes and light emitting diodes.

(30) Priority : **26.05.87 US 53914**

(43) Date of publication of application :
**30.11.88 Bulletin 88/48**

(45) Publication of the grant of the patent :
**10.04.91 Bulletin 91/15**

(84) Designated Contracting States :
**DE FR GB**

(56) References cited :
W. SCHMIDT et al.: "Optoelektronik kurz und bündig", 1975, pages 130-131, Vogel-Verlag, Würzburg, DE
SIEMENS-BAUTEILE-INFORMATIONEN, vol. 11, no. 1, April 1973, pages 14-15, Munich, DE; F. KEINER et al.: "Einfache Schaltung zum eliminieren des Temperaturkoeffizienten von Lumineszenzdioden"

(56) References cited :
PATENT ABSTRACTS OF JAPAN, vol. 11, no. 148 (E-506)(2595), 14th May 1987 & JP A 61 287 280
PATENT ABSTRACTS OF JAPAN, vol. 6, no. 189 (E-133)(1067), 28th September 1982 & JP A 57 102 085
PATENT ABSTRACTS OF JAPAN, vol. 6, no. 155 (E-125)(1033), 17th August 1982 & JP A 57 76 884

(73) Proprietor : **Hughes Aircraft Company**
**7200 Hughes Terrace P.O. Box 45066**
**Los Angeles, California 90045-0066 (US)**

(72) Inventor : **de la Chapelle, Michael**
**22923 Cantlay Street**
**Canoga Park California 91307 (US)**

(74) Representative : **Kuhnen, Wacker & Partner**
**Schneggstrasse 3-5 Postfach 1553**
**W-8050 Freising (DE)**

## Description

## BACKGROUND OF THE INVENTION

### 1. Field of the invention

The present invention relates to a nonfeedback stabilized bias circuit for an optical energy emitting semiconductor diode such as laser diodes and light emitting diodes for producing a predetermined constant optical energy output, and to a method for optimally stabilizing the optical energy output about a constant value of a semiconductor diode, and, more particularly, to a diode biasing circuit that stabilizes the optical output power over a wide temperature range, and method therefore.

### 2. Description of Related Art

Laser diodes and light emitting diodes (LED) are in present day widespread use both for military applications as well as in the domestic market for use in compact disc players, autofocus cameras, remote control units and intrusion alarms, to name but a few. These diodes exhibit a relatively wide variation in optical output power as a function of temperature. Although for military or space applications the temperature range within which diodes are required to function is larger, even for domestic uses they may have to operate in a range exceeding 0-50° Celsius (32-122° Fahrenheit).

Typically, biasing of lasers and LEDs is accomplished by a constant current source. Also, in order to overcome or alleviate the temperature effect where optical power output is desired to be relatively constant, at the present time it is conventional to use feedback circuits which sense any changes in optical power output and adjust the bias current accordingly. Although feedback stabilization bias circuits are effective for maintaining the optical output very precisely they are relatively expensive and too bulky for many applications.

In "Siemens-Bauteile-Informationen", Vol. 11, No. 1, 1973, pages 14-15, a nonfeedback circuit is disclosed, which comprises a constant voltage source and two resistors for eliminating the influence of temperature coefficient of light emitting diodes (LED). The first resistor is connected in parallel with the LED, and the second resistor is connected in series with this parallel circuit. With increasing temperature the voltage of the LED decreases, varying the current distrubution of the circuit. By optimally adjusting the values of both resistors, the voltage drop of the LED is compensated due to the increasing current through the LED.

From "Optoelektronik kurz und bündig" 1975, Vogel Verlag, Würzburg, DE, pages 130-131, a circuit for stabilizing the working-point of a light emitting diode (LED) is disclosed, which comprises a serial resistor and a constant voltage source.

## SUMMARY OF THE INVENTION

It is a fundamental feature of the present invention that for each prescribed optical output power level of an optical energy producing diode, there is an optimum bias line for achieving this prescribed optical ouptut power over a wide temperature range. One aspect of the invention is a bias circuit which causes the diode to operate on the optimum bias line to maintain a constant optical output power, which bias circuit can optionally consist of a voltage source version or a current source version. A further aspect of the invention is a method for stabilizing the optical energy output of a semiconductor diode over a temperature range. The slope and intercepts of the optimum bias line define the component values of the bias circuit.

In the practice of the method of this invention, to determine the value of the biasing voltage (or current) and the electrical resistance to be inserted into the biasing path, the diode is electrically biased to provide the desired amount of optical output at a fixed environmental temperature. This operation is repeated several times at different temperatures and the bias points are plotted on an I-V graph forming a bias line that provides temperature stabilization of the diode optical output power. The slope of the bias line is the optimum bias circuit resistance and the zero axis intercepts the power supply voltage or current, as the case may be. When this biasing circuit is connected with the diode, the optical output is maintained substantially constant over a wide temperature range. The invention may also be accomplished using a constant current source, in which case the stabilizing resistance is shunted about the diode.

Whether to practice the present invention by utilizing a voltage source or a current source is determined primarily by the amount of power dissipation expected in the bias resistor. Where the resistance is a relatively high value, it is advisable to use a current source and shunt the resistor about the diode. On the other hand, where the bias resistor is a relatively low value, it is advisable to use a voltage source with a series resistance to the diode.

The stabilized bias circuits and the methods of stabilizing the optical energy output of a semiconductor diode according to the invention are featured in claims 1-4.

## BRIEF DESCRIPTION OF THE DRAWINGS

In the accompanying drawings :
FIG. 1A is a prior art schematic of constant current biasing of an optical energy producing diode;
FIG. 1B is a prior art circuit to bias a diode for simple display purposes ;

FIG. 1C is a schematic circuit of a prior art feedback control circuit for a diode to obtain optical output stabilization over a temperature range ;

FIG. 2 is a schematic depiction of the circuit of this invention with a biasing voltage and a series resistance determined by the method of the invention ;

FIG. 3 is an alternate embodiment of the invention in which the diode is biased by a constant current source ;

FIG. 4 is an I-V graph for constant optical output power at various temperatures. For the conversion of the temperature from °F to °C, the following formula applies : $T(°C) = \frac{5}{9} [T(°F) - 32]$.

FIG. 5 is a graph comparing the optical output power versus temperature for operation under the invention as compared with the prior art constant current bias.

## DESCRIPTION OF THE PREFERRED EMBODIMENTS

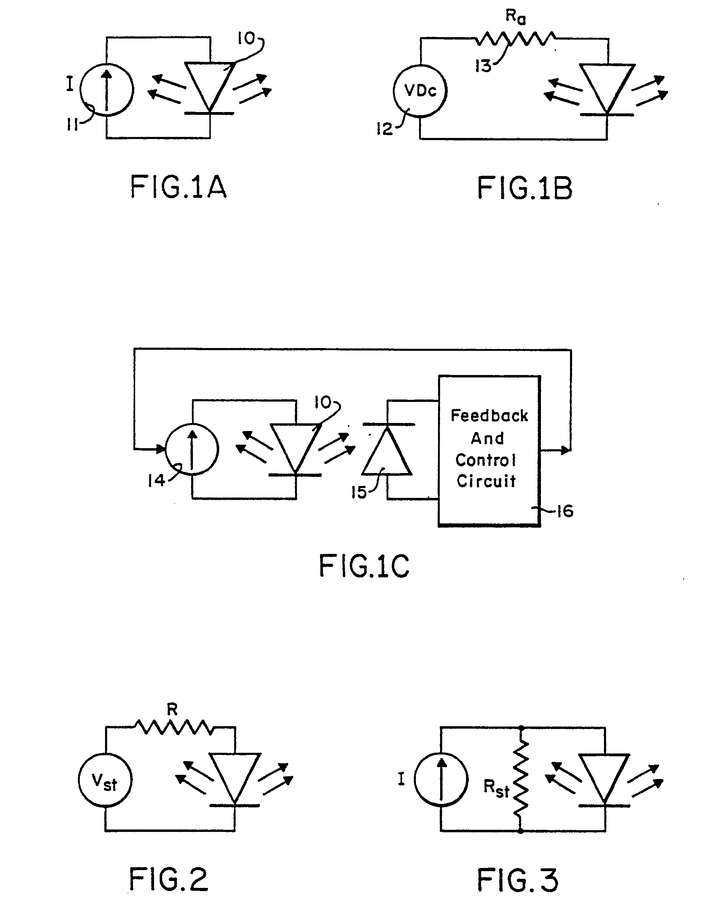

Turning now to the drawing and particularly FIG. 1A, there is shown a typical prior art energizing circuit for an optical energy producing semiconductor diode 10 such as a so-called laser diode or a light emitting diode (LED). Energizing power has conventionally been provided by a constant current source 11 where it is not necessary to stabilize the optical output power. The optical output, however, is found to vary considerably with diode temperature. For example, one commercially available diode under constant current biasing provides approximately 1.9 milliwatts at 32° Fahrenheit (0° Celsius) and only 0.9 milliwatts at 70°F. (21°C.).

Where diodes are used as simple display devices, for example, variation in light output is not important and diode temperature stability is of minor concern. However, there are other applications such as optical fiber transmitters for telecommunications links where temperature stability is mandatory.

Where diodes are used for simple display applications it is common practice to employ a voltage source 12 with a series resistance (Ra) for diode biasing as depicted in FIG. 1B. This technique is adopted primarily because a constant current bias is too expensive for simple display applications. Accordingly, a series resistance is chosen of appropriate value to merely deliver an effective value current to the diode. There has been no thought or appreciation in past of using a series resistance to achieve temperature stabilization.

Diode temperature stabilization has been achieved by a feedback arrangement in the past as depicted in FIG. 1C. As shown there, the diode 10 is primarily biased by a controllable current source 14. In addition, the diode output is directed onto a back plane photodiode 15 interconnected with a null-balance feedback control circuit 16. In this way, temperature induced changes in the optical output power are compensated for by in creasing or decreasing the biasing current, as the case may be. Although this method provides excellent stability, feedback stabilization is relatively expensive, and, for certain applications, too bulky.

It is a fundamental feature and aspect of the present invention to provide an energization circuit for a laser or light emitting diode maintaining a predetermined constant optical energy output over an extended temperature range, which circuit accomplishes this goal simply, relatively inexpensively and without relying on feedback techniques.

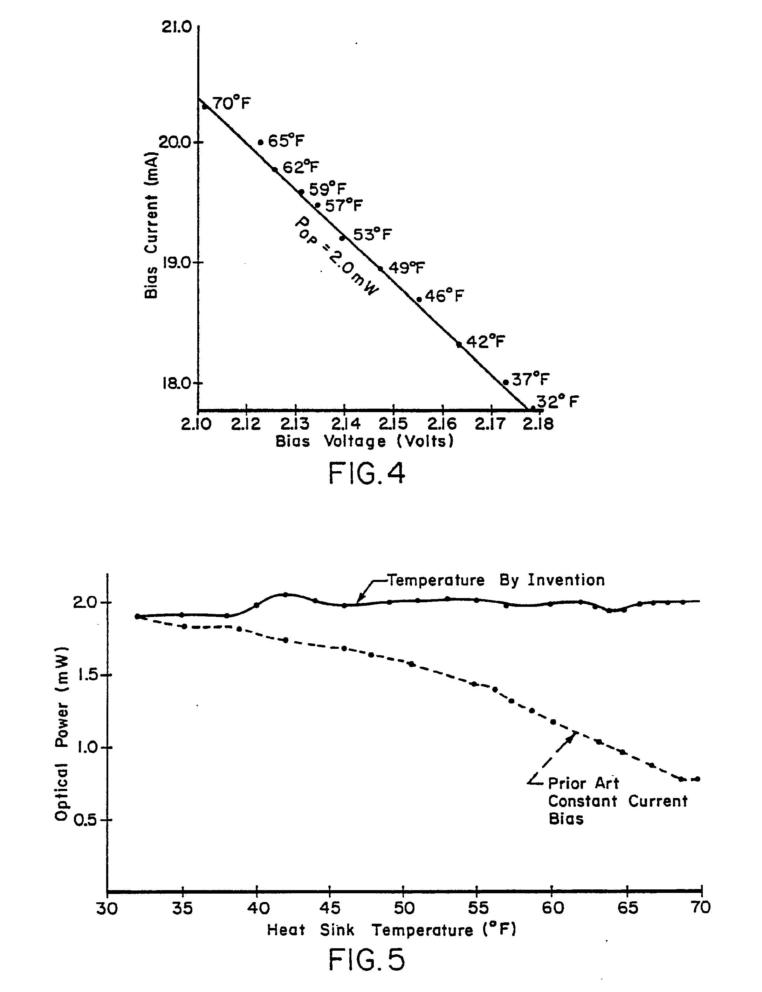

Turning now to FIG. 4, there is shown a graph of diode bias current and voltage over a temperature range of 32-72°F. (0-22°C.) for a constant optical output. More particularly, the graph shows values of D.C. biasing voltage and current for a given laser diode to produce 2.0 milliwatts of optical output power at a number of different temperatures.

The FIG. 4 graph is formed from data made on a GaAlAs laser diode manufactured and sold under the trade designation LDS10 by Ortel Corporation, Alhambra, CA. The straight line curve is actually a best-fit line drawn through the various I-V measurement points made at the indicated temperatures. This bias line has been determined to represent the optimum bias line for minimizing optical output power variations with temperature. It has also been found that the optimum bias line changes for different optical output power levels.

From the FIG. 4 graph, the value of the bias voltage for zero current (i.e., open circuit voltage) was found to be 2.403 volts. Also, the inverse slope of the bias line defines a resistance, Rst, equal to 12.4 ohms. These are, respectively, the values of a constant bias voltage source and series resistance for a diode energization circuit to achieve the predetermined constant optical output (i.e., 2.0 mw) stabilized over a wide temperature range (FIG. 2).

In a practical operating construction of the invention, a D.C. voltage source of 2.403 volts was applied through a 12.4 ohm series resistor to bias an LDS10 diode. The diode was maintained in contact with a heat sink which was varied in temperature. For comparison, an identical diode was biased by a constant current of 20.4 milliamperes while a heat sink in contact with the diode was similarly varied in temperature. The optical energy output of each diode was measured and plotted. As FIG. 5 shows, the bias circuit of the invention is highly constant at approximately 2.0 milliwatts throughout the entire temperature range, while the constant current bias controlled diode drops off in light output as the temperature increases until it is approximately 0.75 milliwatts at about 68°F.

In the first described embodiment an appropriate voltage was determined for use with Rst to bias the diode to constant light output. As an alternative, a circuit as in FIG. 3 can be used where the same resistance Rst (i.e., 12.4 ohms) is shunted about the diode and bias is provided by a constant current source equal to the current at the voltage zero intercept (i.e., V = 0) taken from FIG. 4.

The choice between using the invention with a voltage source (FIG. 2) or a current source (FIG. 3) depends primarily upon the expected power dissipation in the bias resistor Rst. Although stabilization of optical output can be achieved by utilizing either a voltage or current source, it is usually advisable to employ the one exhibiting the least power dissipation across the resistor if only in the interest of driving power conservation.

## Claims

1. A nonfeedback stabilized bias circuit for an optical energy emitting semiconductor diode producing a predetermined constant optical energy output, over a temperature range, comprising :
   a DC voltage source having a constant voltage value substantially equal to the zero current intercept of a best-fit straight line for a plurality of bias points on a voltage-current graph of said diode for producing the said predetermined optical energy output at respectively different temperatures ; and
   a resistor serially interconnected with said constant voltage source and said diode, said resistor having a value in ohms equal to the ratio of voltage variation over a certain portion of the best-fit straight line to current variation over the same said portion.

2. A nonfeedback stabilized bias circuit for biasing an optical energy emitting semiconductor diode producing a predetermined constant optical energy output over a temperature range, comprising :
   a DC electrical energy source providing a constant current of a value substantially equal to the zero voltage intercept of a best-fit straight line for a plurality of bias points on a votage-current graph of said diode for producing the said predetermined constant optical energy output at respectively different temperatures ;
   a resistor parallelly interconnected with said DC electrical energy source and said diode, said resistor being of a value in ohms equal to the ration of voltage variation along a portion of the straight line voltage-current graph to current variation along the same said portion.

3. A method for optimally stabilizing the optical energy output at about a constant value of a semiconductor diode over a temperature range, comprising the steps of :
   locating a plurality of voltage-current points on a graph, each point of which corresponds to biasing necessary to stabilize the diode output at said constant value for a particular temperature ;
   drawing a best-fit straight line through the voltage-current points ;
   extrapolating the line to intersect the voltage point corresponding to zero current ; and
   biasing the diode with a stabilized bias circuit having a constant voltage equal to the said votage point through a series resistor having a value in ohms equal to the ratio of voltage variation over a certain portion the best-fit straight line curve to current variation over the same said portion.

4. A method for optimally stabilizing the optical energy output at about a constant value of a semiconductor diode over a temperature range, comprising the steps of :
   locating a plurality of voltage-current points on a graph, each point of which corresponds to biasing necessary to stabilize the diode output at said constant value for a particular temperature ;
   drawing a best-fit straight-line through the voltage-current points ;
   extrapolating the line to intersect the current point corresponding to zero voltage ; and
   connecting the diode with a stabilized bias circuit having a constant current equal to the said current point through a parallel resistor having a value in ohms equal to the ratio of voltage variation along a portion of the straight line voltage-current graph to current variation along the same said portion.

## Ansprüche

1. Stabilisierungsvorschaltung ohne Rückkopplung für eine Halbleiterdiode zur Aussendung von optischer Energie, welche über einen Temperaturbereich eine vorbestimmte konstante optische Energieabgabe erzeugt, welche aufweist :
   eine Gleichspannungsquelle mit einem konstanten Spannungswert, der im wesentlichen gleich ist dem Nullstrom-Schnittpunkt einer Linie der besten Anpassung für eine Vielzahl von Vorpunkten auf einem Spannungs-Strom-Graphen der Diode für die Erzeugung der vorbestimmten optischen Energieabgabe bei jeweils verschiedenen Temperaturen ; und
   einen seriell mit der Konstantspannungsquelle und der Diode verbundenen Widerstand, wobei der Widerstand einen Wert in Ohm aufweist, der gleich ist dem Verhältnis der Spannungsvariation über einen bestimmten Abschnitt der Linie bester Anpassung zu der Stromvariation über denselben Abschnitt.

2. Stabilisierungsvorschaltung ohne Rückkopplung zum Vorspannen einer Halbleiterdiode für die Abgabe von optischer Energie, welche über einen Temperaturbereich eine vorbestimmte konstante optische Energieabgabe erzeugt, welche aufweist :

eine elektrische Gleichstrom-Energiequelle zum Liefern eines konstanten Stromes mit einem Wert, der im wesentlichen gleich ist dem Nullspannungs-Schnittpunkt einer Linie bester Anpassung für eine Vielzahl von Vorpunkten auf einem Spannungs-Stromgraphen der Diode zum Erzeugen der vorbestimmten konstanten optischen Energieabgabe bei jeweils verschiedenen Temperaturen ;

einen parallel mit der elektrischen Gleichstrom-Energiequelle und der Diode verbundenen Widerstand, wobei der Widerstand einen Wert in Ohm aufweist, der gleich ist dem Verhältnis der Spannungsvariation entlang eines Abschnittes des geradlinigen Spannungs-Strom-Graphen zu der Stromvariation entlang desselben Abschnittes.

3. Verfahren zum optimalen Stabilisieren der optischen Energieabgabe bei etwa einem konstanten Wert einer Halbleiterdiode über einen Temperaturbereich, welches die Schritte aufweist :

Lokalisieren einer Vielzahl von Spannungs-Strom-Punkten auf einem Graphen, wobei jeder Punkt der für die Stabilisierung der Diodenabgabe bei dem konstanten Wert für eine bestimmte Temperatur notwendigen Vorspannung entspricht ;

Ziehen einer Linie bester Anpassung durch die Spannungs-Strom-Punkte ;

Extrapolieren der Linie bis zu dem Schnittpunkt des Spannungspunktes, welcher dem Nullstrom entspricht ; und

Vorspannen der Diode mit einer Stabilisierungsvorschaltung mit einer konstanten Spannung, welche gleich ist dem Spannungspunkt über einem Reihenwiderstand, welcher einen Wert in Ohm aufweist, der gleich ist dem Verhältnis der Spannungsvariation über einen bestimmten Abschnitt der Kurvenlinie bester Anpassung zu der Stromvariation über denselben Abschnitt.

4. Verfahren zum optimalen Stabilisieren der optischen Energieabgabe bei etwa einem konstanten Wert einer Halbleiterdiode über einen Temperturbereich, welches die Schritte aufweist :

Lokalisieren einer Vielzahl von Spannungs-Strom-Punkten auf einem Graphen, wobei jeder Punkt der für die Stabilisierung der Diodenabgabe bei dem konstanten Wert für eine bestimmte Temperatur notwendigen Vorspannung entspricht ;

Ziehen einer Linie bester Anpassung durch die Spannungs-Strom-Punkte ;

Extrapolieren der Linie bis zu dem Strompunkt, welcher der Nullspannung entspricht ; und

Verbinden der Diode mit einer Stabilisierungsvorschaltung mit einem konstanten Strom, der gleich ist dem Strompunkt durch einen Parallelwiderstand mit einem Wert in Ohm, der gleich ist dem Verhältnis der Spannungsvariation entlang einem Abschnitt des geradlinigen Spannungs-Strom-Graphen zu der Stromvariation entlang desselben Abschnittes.

## Revendications

1. Circuit de polarisation stabilisé sans contre-réaction pour diode à semi-conducteur émettrice d'énergie lumineuse produisant une sortie d'énergie lumineuse de valeur constante prédéterminée dans un intervalle de température comprenant :

une source de tension continue de valeur constante sensiblement égale à l'intersection avec la droite de courant zéro de la droite de régression de plusieurs points de polarisation d'une courbe courant-tension de ladite diode pour obtenir ladite sortie d'énergie lumineuse de valeur prédéterminée à différentes températures,

une résistance placée en série avec ladite source de tension constante et ladite diode, ladite résistance ayant une valeur en ohms égale au rapport entre la variation de tension sur un certain segment de la droite de régression et la variation de courant sur le même segment.

2. Circuit de polarisation stabilisé sans contre-réaction pour polariser une diode à semi-conducteur émettrice d'énergie lumineuse produisant une sortie d'énergie lumineuse de valeur constante prédéterminée dans un intervalle de température, comprenant :

une source continue d'énergie électrique fournissant un courant constant de valeur sensiblement égale à l'intersection avec la droite de tension zéro de la droite de régression de plusieurs points de polarisation de la courbe courant-tension de ladite diode pour obtenir ladite sortie d'énergie lumineuse de valeur constante prédéterminée à différentes températures ;

une résistance placée en parallèle avec ladite source continue d'énergie électrique et avec ladite diode, ladite résistance ayant une valeur en ohms égale au rapport entre la variation de tension sur un certain segment de la droite de régression et la variation de courant sur le même segment.

3. Procédé pour stabiliser de façon optimale autour d'une valeur constante la sortie d'énergie lumineuse d'une diode à semi-conducteur dans un intervalle de température comprenant les étapes suivantes :

on reporte plusieurs points courant-tension sur un graphique, chacun des points correspondant à la polarisation nécessaire pour stabiliser la sortie de la diode à ladite valeur constante à une température donnée,

on trace la droite de régression passant entre les différents points courant-tension,

on extrapole la droite jusqu'au point d'intersection donnant la valeur de tension correspondant au courant nul,

on polarise la diode avec un circuit de polarisation stabilisé dont la tension constante égale à ladite valeur de tension est appliquée à une résistance série dont la valeur en ohms est égale au rapport entre la variation de tension sur un segment donné de la droite de régression et la variation de courant sur le même segment de la droite.

4. Procédé pour stabiliser de façon optimale autour d'une valeur constante la sortie d'énergie lumineuse d'une diode à semi-conducteur dans un intervalle de température comprenant les étapes suivantes :

on reporte plusieurs points courant-tension sur un graphique, chacun des points correspondant à la polarisation nécessaire pour stabiliser la sortie de la diode à ladite valeur constante à une température donnée,

on trace la droite de régression passant entre les points courant-tension,

on extrapole la droite jusqu'au point d'intersection donnant la valeur de courant correspondant à la tension nulle, et

on connecte la diode à un circuit de polarisation stabilisé dont le courant constant égal à ladite valeur de courant passe dans une résistance en parallèle ayant une valeur en ohms égale au rapport entre la variation de tension sur un segment donné de la droite de régression et la variation de courant sur le même dit segment.

FIG.1A

FIG.1B

FIG.1C

FIG.2

FIG.3

FIG.4

FIG.5